# EUROPÄISCHE PATENTSCHRIFT

(11) **EP 2 932 227 B1**
(45) Veröffentlichungstag und Bekanntmachung des Hinweises auf die Patenterteilung: **01.11.2017**
(21) Anmeldenummer: 13802319.7
(22) Anmeldetag: 03.12.2013
(51) Int. Cl.: G01M 17/007, B60W 40/06, B60W 40/09, B60W 40/10, G01M 17/04, G01M 17/06, G05B 17/00, G06F 17/50, G06G 7/70, G09B 9/052

(54) **VERFAHREN ZUR BEURTEILUNG DER BEHERRSCHBARKEIT EINES FAHRZEUGES**
METHOD FOR ASSESSING THE CONTROLLABILITY OF A VEHICLE
PROCÉDÉ D'ÉVALUATION DU DEGRÉ DE CONTRÔLE D'UN VÉHICULE

(30) Priorität: 12.12.2012 AT 505842012
(43) Veröffentlichungstag der Anmeldung: 21.10.2015
(73) Patentinhaber: AVL List GmbH, 8020 Graz (AT)
(72) Erfinder: NICA, Mihai, A-8051 Graz (AT); MIEDL, Christian, 94560 Offenberg (DE); SAMS, Theodor, A-8010 Graz (AT); ZIEHER, Franz, A-8045 Graz (AT); GRIESSNIG, Gerhard, A-8053 Graz (AT); GEYER, Dirk, 93142 Leonberg (DE); CAIZHEN, Cheng, A-8020 Graz (AT); ROSENBERGER, Thomas, A-8142 Zwaring-pöls (AT); JONES, Stephen, A-8051 Graz (AT); BRAUN, Jürgen, 93164 Laaber (DE); KURAL, Emre, A-8010 Graz (AT); SCHAUER, Johannes, A-8010 Graz (AT); ALBRECHT, Rolf, A-8020 Graz (AT)
(74) Vertreter: Babeluk, Michael
(86) Internationale Anmeldenummer: PCT/EP2013/075354
(87) Internationale Veröffentlichungsnummer: WO 2014/090631

(56) Entgegenhaltungen:
- EP-A1- 2 246 686
- US-A- 5 880 362
- Tesis Dynaware Gmbh: "ve-DYNA Professional Real-Time Vehicle Dynamics Simulation Environment", , 1. Dezember 2012 (2012-12-01), Seiten 1-4, XP055125747, Gefunden im Internet: URL:http://www.tesis-dynaware.com/fileadmi n/Downloads/Flyer_Broschueren/veDYNA/Produ ct_overview_vedyna.pdf [gefunden am 2014-06-27]

## Beschreibung

Die Erfindung betrifft ein Verfahren zur Beurteilung der Beherrschbarkeit eines Fahrzeuges, insbesondere eines Elektrofahrzeuges, durch einen Fahrer in Risiko-oder Problemsituationen.

Um systematisch das Risiko bei gefährlichen Fehlern in elektrischen und elektronischen Systemen in Fahrzeugen bewerten zu können, wurde die ISO-Norm 26262 eingeführt. In der Norm werden Voraussetzungen genannt, die erfüllt sein müssen, damit das zu entwickelnde System eine geforderte Sicherheitsanforderungsstufe ASIL (automotive safety integrity level) erfüllen kann. Dabei werden Anforderungen bezüglich der Durchführung einer Gefährdungsanalyse und Risikoabschätzung definiert. Dazu müssen zunächst die potentiellen Gefährdungen des Systems identifiziert werden. Dies geschieht durch Betrachtung der Fehlfunktionen des untersuchten Systems in spezifischen Fahrtsituationen. Anschließend wird jede Gefährdung mit einer Sicherheitsanforderungsstufe von A bis D klassifiziert bzw. als nicht sicherheitsrelevant eingeordnet. Die Risikoanalyse geschieht in der ISO-Norm 26262 mittels einer festgelegten qualitativen Methodik. Dazu muss für jede identifizierte Gefährdung einzeln die Schwere (severity-S) der Auswirkung, die Häufigkeit (exposure-E) der Fahrsituation und die Beherrschbarkeit (controllability-C) der Fehlfunktion in der jeweiligen Fahrsituation zum Beispiel durch den Fahrer abgeschätzt werden. Mit steigender Sicherheitsanforderungsstufe ASIL steigen auch die Anforderungen an die Sicherheit - daher hat die Sicherheitsanforderungsstufe einen hohen Einfluss auf die Entwicklungskosten.

Während es für die Bewertung der Schwere der Auswirkungen und der Häufigkeit der Fahrsituation klare Richtlinien gibt, ist die Beherrschbarkeit der Fahrsituation bisher schwer objektiv abschätzbar. Gemäß der ISO-Norm 26262 wird die Beherrschbarkeit der Fahrsituation in die Klassen C0 (beherrschbar) bis C3 (unbeherrschbar) eingeteilt. Das dabei auftretende Problem ist, dass die meisten Beherrschbarkeits-Annahmen erst am Ende eines Entwicklungszyklus am Versuchsstand in einer geeigneten Untersuchung verifizierbar sind. Dies ist besonders dann unangenehm, wenn sich dabei herausstellt, dass die Beherrschbarkeit unrichtig während des Projektes angenommen wurde und die Sicherheitsanforderungsstufe des Systems neu bestimmt werden muss, wodurch Teile der Entwicklungsarbeit wiederholt werden müssen.

Aus der Broschüre "ve-DYNA® Professional Real-Time Vehicle Dynamics Simulation Environment" der Tesis Dynaware GmbH, München, vom 1. Dezember 2012, Seiten 1 bis 4, XP055125747, URL: http://www.tesis-dynaware.com/fileadmin/Downloads/Flyer_Broschueren/veDYNA/Product_overvie w_vedyna.pdf ist eine Fahrzeugdynamik-Simulationsumgebung für virtuelle Testfahrten zur Beurteilung der Beherrschbarkeit eines Fahrzeugs, und insbesondere zur Berechnung einer Abweichung von einer geplanten Bahnkurve bekannt.

Aufgabe der Erfindung ist es, diese Nachteile zu vermeiden und ein Verfahren zu entwickeln, welches es erlaubt, bereits frühzeitig eine Beurteilung der Beherrschbarkeit eines Fahrzeuges durchzuführen.

Erfindungsgemäß wird dies durch folgende Schritte erreicht:
a. Modellieren des Antriebsstranges und der Fahrdynamik des Fahrzeugs,
b. Modellieren von Situations- und Umweltbedingungen,
c. Auswählen zumindest einer Risiko- oder Problemsituation,
d. Auswählen zumindest eines Fahrerbefähigungstyps, vorzugsweise aus der Gruppe unerfahrener Fahrer, durchschnittlicher Fahrer und fortgeschrittener Fahrer,
e. Modellieren der Fahrerreaktion in Abhängigkeit des ausgewählten Fahrerbefähigungstyps,
f. Simulieren des dynamischen Fahrzeugverhaltens längs- und quer zu einer geplanten Bahnkurve auf der Basis des Antriebsstrang- und Fahrdynamikmodells für die vorgegebenen Situations- und Umweltbedingungen bei Eintreten der ausgewählten Risiko- oder Problemsituation unter Annahme eines Fahrereingriffes mit fahrerbefähigungstypabhängiger Reaktionszeit,
g. Berechnen der maximalen lateralen und longitudinalen Abweichung von der geplanten Bahnkurve zwischen dem Auftreten der Risiko- oder Problemsituation und der Wiedererlangung der vollen Kontrolle durch den Fahrer,
h. Bewerten der Beherrschbarkeit des Fahrzeugs durch den Fahrer in der Risiko- oder Problemsituation auf Grund der maximalen lateralen und/oder longitudinalen Abweichung des Fahrzeugs von der geplanten Bahnkurve.

Das vorliegende Verfahren erlaubt es frühzeitig die Beherrschbarkeit des Fahrzeugs durch den Fahrer in Risiko- und Problemsituationen in den Risiko- und Problemanalysen abschätzen zu können, sowie Aussagen über die Reaktionszeit im Falle eines Fehlers im System treffen zu können. Der große Vorteil liegt darin, dass bereits in einer sehr frühen Entwicklungsphase die Beherrschbarkeit des Fahrzeugs berücksichtigt werden kann. Das Verfahren basiert dabei auf Simulationen der lateralen und longitudinalen Fahrdynamik des Fahrzeugs für die verschiedensten Fahrbedingungen (z.B. trockene, nasse oder eisige Straße; Geschwindigkeiten; Kurven; etc.), wobei die verschiedensten Fehler in Bezug auf das betrachtende System berücksichtigt werden können (zum Beispiel Fehler der elektrischen Maschine bei einem Elektrofahrzeug). Auf Grund des Simulationsergebnisses kann die Reaktionsfähigkeit des Fahrers bei auftretenden Problemen untersucht werden.

Zusätzlich können die Ergebnisse der Simulation für Sicherheitsuntersuchungen verwendet werden.

Die Gefährdungsanalyse und Risikoabschätzung wird gemäß ISO-Norm 26262 durchgeführt. Auf Basis dieser werden relevante riskante Risiko- und Problemsituationen zur Durchführung der Simulation ausgewählt, zum Beispiel volle Drehmomentfreisetzung in einer Kurve. Für jede dieser Situationen erfolgt zusätzlich zur Fehlerdefinition eine vollständige Beschreibung der Situationsbedingungen, wie beispielsweise der Fahrgeschwindigkeit, der Straßenverhältnisse, der Sichtverhältnisse, der Witterungsbedingungen, etc.

Der Antriebsstrang des Fahrzeugs wird mit geeigneten Software-Werkzeugen (zum Beispiel Software "AVL CRUISE") modelliert. Wenn ein komplexes System wie ein Antriebsstrang analysiert wird, können auch andere Werkzeuge zur Modellierung von Unterkomponenten eingesetzt und in das Antriebsstrangmodell integriert werden.

Die Modellierung der Fahrzeugdynamik und die Simulation der Situationsbedingungen kann mit einem Software-Werkzeug durchgeführt werden, welches eine Simulation der lateralen und longitudinalen Dynamik ermöglicht, beispielsweise mit der Fahrdynamik-Simulationsplattform "CARMAKER" (IPG).

Es werden mehrere Befähigungstypen von Fahrern modelliert: unerfahren (entsprechend dem Beherrschbarkeitsniveau C0 der ISO 26262), durchschnittlich (entsprechend dem Beherrschbarkeitsniveau C1) und fortgeschritten (entsprechend dem Beherrschbarkeitsniveau C2). Diese Fahrermodellierung wird realisiert durch unterschiedliche Reaktionszeiten für jedes Fahrermodel. Zusätzlich wird die aktuelle Reaktion des Fahrers in Abhängigkeit des Fahrerbefähigungstyps modelliert. Das bedeutet, dass beispielsweise ein fortgeschrittener Fahrer energischer gegensteuert oder eine stärkere Bremskraft aufbringen wird, als ein unerfahrener oder durchschnittlicher Fahrer.

Für jede der drei Fahrerbefähigungstypen wird jede Situation hinsichtlich Beherrschbarkeit oder Unbeherrschbarkeit untersucht.

Für Risiko- oder Problemsituationen mit seitlicher Krafteinwirkung auf das Fahrzeugs wird eine Risiko- oder Problemsituation als unbeherrschbar angesehen, wenn während der Zeit, während der der Fahrer versucht, die Kontrolle über das Fahrzeug wiederzuerlangen, das Fahrzeug zumindest um einen definierten Grenzwert - beispielsweise 0,5 Meter, oder mehr - seitlich von der Soll-Fahrtroute bzw. der Soll-Fahrspur abweicht. Unter lateraler Abweichung wird dabei der Betrag verstanden, um welchen die durch die Risiko- oder Problemsituation verursachte seitliche Bewegung des Fahrzeugs von der geplanten Bahnkurve abweicht. Der Grenzwert, bis zu dem die Situation als beherrschbar eingestuft wird, kann dabei in Abhängigkeit der Straße flexibel definiert werden. Auf Autobahnen kann dieser Grenzwert größer, auf schmalen Straßen kleiner als 0,5 Meter sein. 0,5 Meter können aber als Durchschnittsgrenzwert für die meisten Straßen angenommen werden.

Für Risiko- oder Problemsituationen mit Krafteinwirkung auf das Fahrzeugs längs zur Fahrtrichtung wird die Beherrschbarkeit in Sekunden (oder Meter) zwischen zwei Fahrzeugen gemessen. Als Bezugswerte für den Grenzwert werden dabei die gesetzlichen Vorschriften in dem Land verwendet, in welchem bzw. für welches das Fahrzeug entwickelt wird. In den meisten europäischern Ländern ist beispielsweise ein zwei Sekunden-Abstand zwischen zwei Fahrzeugen (oder entsprechender Abstand in Metern) vorgeschrieben. Eine Risiko- oder Problemsituation wird dabei dann als beherrschbar angesehen, wenn die Abweichung in Längsrichtung der geplanten Bahnkurve des Fahrzeugs nicht mehr als 1,5 Sekunden (0,5 Sekunden Toleranz) beträgt. Als longitudinale Abweichung wird der Betrag verstanden, um den die Längsbewegung des Fahrzeuges, verursacht durch die Risiko- oder Problemsituation, von dem durch den Fahrer geplanten Bahnpunkt abweicht. Die longitudinale Abweichung hängt dabei von der simulierten Situation, also dem für sicher erachteten Abstand (zum Beispiel 2 Sekunden) zwischen zwei hintereinander fahrenden Fahrzeugen, ab, und kann situationsbedingt variieren. Für stehende oder startende Fahrzeuge wird die longitudinale Abweichung innerhalb der eine Risiko- oder Problemsituation als beherrschbar angenommen wird, mit etwa 1 Meter angenommen.

Wenn bei Risiko- oder Problemsituationen mit sowohl lateralen, als auch longitudinalen Kraftkomponenten auf das Fahrzeug irgendeine der lateralen oder longitudinalen Abweichungen über den jeweiligen Grenzwerten liegt, wird eine Risiko-oder Problemsituation dann als beherrschbar angesehen, wenn während der Zeitdauer, in welcher der Fahrer versucht, die Kontrolle über das Fahrzeug wiederzuerlangen, die laterale Abweichung den lateralen Grenzwert (beispielsweise 0,5 Meter) außerhalb der Grenzen der vom Fahrzeug benutzten Fahrbahn oder den longitudinalen Grenzwert (beispielsweise 1,5 Sekunden) von der durch den Fahrer geplanten Bahnpunkt nicht überschreitet. Für ein stehendes oder startendes Fahrzeug wird als longitudinaler Grenzwert 1 Meter angenommen.

Abhängig von den Fahrerbefähigungstypen wird mit folgenden Reaktionszeiten gerechnet:
Unerfahrene Fahrer (entsprechend der Beherrschbarkeitsklasse C0): 2,3 bis 2,8 Sekunden;

Durchschnittliche Fahrer (entsprechend der Beherrschbarkeitsklasse C1): 1,8 bis 2,1 Sekunden.

Fortgeschrittene Fahrer (entsprechend der Beherrschbarkeitsklasse C0): 1,5 bis 1,8 Sekunden.

Eine Risiko- oder Problemsituation wird dann als unbeherrschbar (Beherrschbarkeitsklasse C3) angesehen, wenn keine der Fahrerbefähigungstypen (entsprechend den Beherrschbarkeitsklassen C0, C1, C2) im Stande ist, innerhalb der gesetzten Grenzwerte sowohl für die laterale Abweichung, als auch für die longitudinale Abweichung die Kontrolle über das Fahrzeug wiederzuerlangen.

Eine Risiko- oder Problemsituation wird dann als allgemein beherrschbar (Beherrschbarkeitsklasse C0) angesehen, wenn jede der Fahrerbefähigungstypen (entsprechend den Beherrschbarkeitsklassen C0, C1, C2) im Stande ist, innerhalb der gesetzten Grenzwerte sowohl für die laterale Abweichung, als auch für die longitudinale Abweichung die Kontrolle über das Fahrzeug wiederzuerlangen.

Als durchschnittlich beherrschbar (Beherrschbarkeitsklasse C1) wird eine Risiko-oder Problemsituation dann angesehen, wenn sowohl der durchschnittliche als auch der fortgeschrittene Fahrerbefähigungstyp (entsprechend den Beherrschbarkeitsklassen C1, C2) im Stande ist, innerhalb der gesetzten Grenzwerte sowohl für die laterale Abweichung, als auch für die longitudinale Abweichung die Kontrolle über das Fahrzeug wiederzuerlangen.

Eine Risiko- oder Problemsituation wird dann als fortgeschritten beherrschbar (Beherrschbarkeitsklasse C2) angesehen, wenn nur der fortgeschrittene Fahrerbefähigungstyp (entsprechend den Beherrschbarkeitsklassen C2) im Stande ist, innerhalb der gesetzten Grenzwerte sowohl für die laterale Abweichung, als auch für die longitudinale Abweichung die Kontrolle über das Fahrzeug wiederzuerlangen.

Die niedrigste Beherrschbarkeitsklasse aller erfolgreich simulierten Fahrerbefähigungstypen gibt eine Aussage über die Beherrschbarkeit des Fahrzeugs in der ausgewählten Risiko- oder Problemsituation. Auf Basis dieses Ergebnisses kann eine Gefährdungs- und Risikoabschätzung beispielsweise nach ISO-Norm 26262 durchgeführt werden.

Die Erfindung wird anhand der Fig. näher erläutert. Es zeigen schematisch:
- Fig. 1: das erfindungsgemäße Verfahren in einem Flussdiagramm; und
- Fig. 2: eine Einrichtung zur Durchführung des erfindungsgemäßen Verfahrens.

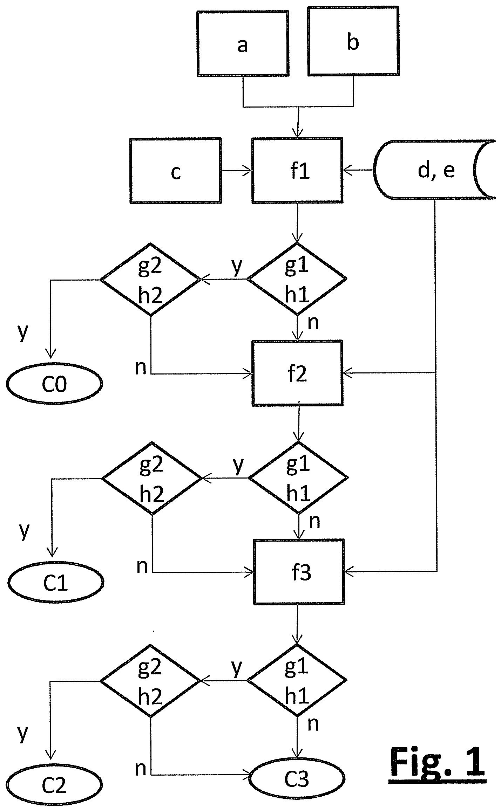

Die Fig. 1 zeigt das erfindungsgemäße Verfahren zur Beurteilung der Beherrschbarkeit eines Fahrzeuges, beispielsweise eines Elektrofahrzeuges oder eines Hybridfahrzeuges, durch einen Fahrer in Risiko- oder Problemsituationen, an Hand eines Flussdiagramms.

Nach Starten des Verfahrens wird in Schritt a eine Modellierung des Antriebsstranges und der Fahrdynamik vorgenommen. Die Modellierung des Antriebsstranges und von Antriebsstrangkomponenten kann mit geeigneten bekannten Software-Werkzeugen, beispielsweise "AVL CRUISE" oder dergleichen, erfolgen.

In Schritt b erfolgt eine Modellierung der Situations- und Umweltbedingungen, wobei Situations- und Umweltbedingungen vollständig definiert werden. Dabei werden äußere Faktoren wie Straßenzustand, Fahrbahnrauhigkeit, Sichtverhältnisse, Wetterbedingungen, Tageszeit, Temperatur, etc. beschrieben. Die Modellierung der Fahrdynamik und der Situations- und Umweltbedingungen kann ebenfalls mit einem Software-Werkzeug durchgeführt werden, welches eine Simulation der lateralen und longitudinalen Dynamik ermöglicht, beispielsweise mit der Fahrdynamik-Simulationsplattform "CARMAKER" (IPG).

In Schritt c wird aus einer Bibliothek oder einer Tabelle von abgespeicherten möglichen Risiko- und Problemsituationen zumindest eine Risiko- oder Problemsituation ausgewählt und entsprechende Informationen, Parameter und Routinen für die Simulation des Fahrzeugverhaltens bei Auftreten der Risiko- oder Problemsituation zur Verfügung gestellt.

In Schritt d wird der Fahrerbefähigungstyp aus der zum Beispiel als Tabelle angelegten Gruppe unerfahrener, durchschnittlicher und fortgeschrittener Fahrer ausgewählt und in Schritt e entsprechende Parameter, wie zum Beispiel der Reaktionszeit des Fahrers, in einer Modellierung der Fahrerreaktion in Abhängigkeit des Fahrerbefähigungstyps bereitgestellt.

Mit den Daten und Informationen aus den Schritten a, b und c wird in den Schritten f1, f2 und f3 für alle Fahrerbefähigungstypen eine Simulation des Fahrzeugverhaltens bei der eintretenden Risiko- oder Problemsituation durchgeführt.

Zunächst wird in Schritt f1 die Simulation für einen unerfahrenen Fahrer durchgeführt. Dazu wird in Schritt g1 die maximale laterale Abweichung und in Schritt g2 die maximale longitudinale Abweichung des Fahrzeuges von der geplanten Bahnkurve zwischen dem Auftreten der Risiko- oder Problemsituation bis zur Wiedererlangung der vollen Kontrolle durch den Fahrer berechnet. Anschließend wird in Schritt h1 bzw. h2 bewertet, ob der Fahrer in dieser Situation das Fahrzeug beherrscht oder nicht. Diese Bewertung erfolgt auf Grund eines Vergleiches der maximalen lateralen bzw. longitudinalen Abweichung des Fahrzeuges in der Risiko- oder Problemsituation von dem geplanten Bahnpunkt auf der Bahnkurve ohne Risiko- oder Problemsituation mit einem definierten Grenzwert für diese Abweichung. Der Grenzwert für die laterale Abweichung von der Bahnkurve kann beispielsweise 0,5 Meter betragen. Der Grenzwert für die longitudinale Abweichung kann - in Anlehnung an den minimal erlaubten Abstand zwischen zwei hintereinanderfahrenden Fahrzeugen von etwa 2 Sekunden - mit 1,5 Sekunden angenommen werden. Die Grenzwerte können aber - abhängig von der jeweiligen Situation, der Straßenbreite und der lokalen Gesetzeslage - auch von diesen Werten abweichen. Insbesondere kann der Grenzwert für die longitudinale Abweichung auch durch eine Wegstrecke definiert werden.

Ergibt die Bewertung h1 und h2 dieser Simulation, dass das Fahrzeug durch den Fahrbefähigungstyp "unerfahrener Fahrer" beherrschbar ist ("y"), so wird als Ergebnis der Beherrschbarkeitsbeurteilung die Beherrschbarkeitsklasse "C0" ausgegeben.

Wenn jedoch entweder die laterale oder longitudinale Abweichung größer als der erlaubte Grenzwert ist, so gilt das Fahrzeug für diesen Fahrbefähigungstyp in der ausgewählten Risiko- oder Problemsituationen als nicht beherrschbar ("n") - die Simulation wird mit dem nächsten Fahrbefähigungstyp "durchschnittlicher Fahrer" in der gleichen Weise fortgesetzt.

Ergibt die Bewertung h1 und h2 dieser Simulation, dass das Fahrzeug durch den Fahrbefähigungstyp "durchschnittlicher Fahrer" beherrschbar ist ("y"), so wird als Ergebnis der Beherrschbarkeitsbeurteilung die Beherrschbarkeitsklasse "C1" ausgegeben.

Bei Nichterfüllen der Grenzwerte für die laterale oder longitudinale Abweichung ("n") gilt das Fahrzeug für einen durchschnittlichen Fahrer in dieser Risiko- oder Problemsituationen als nicht beherrschbar. In diesem Falle wird die Simulation auch noch für den letzten Fahrbefähigungstyp "fortgeschrittener Fahrer" in der beschriebenen Weise fortgesetzt.

Wenn sich in der fortgesetzten Simulation herausstellt, dass das Fahrzeug durch den Fahrbefähigungstyp "fortgeschrittener Fahrer" beherrschbar ist ("y"), so wird als Ergebnis der Beherrschbarkeitsbeurteilung die Beherrschbarkeitsklasse "C2" ausgegeben. Andernfalls wird das Fahrzeug mit "C3" als in der behandelten Risiko- oder Problemsituation unbeherrschbar eingestuft.

Für Risiko- oder Problemsituationen mit seitlicher Krafteinwirkung auf das Fahrzeugs wird eine Risiko- oder Problemsituation als unbeherrschbar angesehen, wenn während der Zeit, während der der Fahrer versucht, die Kontrolle über das Fahrzeug wiederzuerlangen, das Fahrzeug zumindest um einen definierten Grenzwert von beispielsweise 0,5 Meter seitlich von der Soll-Fahrtroute bzw. der Soll-Fahrspur abweicht. Unter lateraler Abweichung wird dabei der Betrag verstanden, um welchen die durch die Risiko- oder Problemsituation verursachte seitliche Bewegung des Fahrzeugs von der geplanten Bahnkurve abweicht. Der Grenzwert, bis zu dem die Situation als beherrschbar eingestuft wird, kann dabei in Abhängigkeit der Straße flexibel definiert werden. Auf Autobahnen kann dieser Grenzwert größer, auf schmalen Straßen kleiner als 0,5 Meter sein. 0,5 Meter können aber als Durchschnittsgrenzwert für die meisten Straßen angenommen werden.

Für Risiko- oder Problemsituationen mit Krafteinwirkung auf das Fahrzeugs längs zur Fahrtrichtung wird die Beherrschbarkeit in Sekunden (oder Meter) zwischen zwei Fahrzeugen gemessen. Als Bezugswerte für den Grenzwert werden dabei die gesetzlichen Vorschriften in dem Land verwendet, in welchem das Fahrzeug entwickelt wird. In den meisten europäischern Ländern ist beispielsweise ein zwei Sekunden-Abstand zwischen zwei Fahrzeugen (oder entsprechender Abstand in Metern) vorgeschrieben. Eine Risiko- oder Problemsituation wird dabei dann als beherrschbar angesehen, wenn die Abweichung in Längsrichtung der geplanten Bahnkurve des Fahrzeugs nicht mehr als 1,5 Sekunden (0,5 Sekunden Toleranz) beträgt. Als longitudinale Abweichung wird der Betrag verstanden, um den die Längsbewegung des Fahrzeuges, verursacht durch die Risiko- oder Problemsituation, von dem durch den Fahrer geplanten Bahnpunkt abweicht. Die longitudinale Abweichung hängt dabei von der simulierten Situation, also dem für sicher erachteten Abstand (zum Beispiel 2 Sekunden) zwischen zwei hintereinander fahrenden Fahrzeugen, ab, und kann situationsbedingt variieren. Für stehende oder startende Fahrzeuge wird die longitudinale Abweichung innerhalb der eine Risiko- oder Problemsituation als beherrschbar angenommen wird, mit etwa 1 Meter angenommen.

Wenn bei Risiko- oder Problemsituationen mit sowohl lateralen, als auch longitudinalen Kraftkomponenten auf das Fahrzeug irgendeine der lateralen oder longitudinalen Abweichungen über den jeweiligen Grenzwerten liegen, wird eine Risiko- oder Problemsituation dann als beherrschbar angesehen, wenn während der Zeitdauer, in welcher der Fahrer versucht, die Kontrolle über das Fahrzeug wiederzuerlangen, die laterale Abweichung den lateralen Grenzwert (beispielsweise 0,5 Meter) außerhalb der Grenzen der vom Fahrzeug benutzten Fahrbahn oder den longitudinalen Grenzwert (beispielsweise 1,5 Sekunden) von der durch den Fahrer geplanten Bahnpunkt nicht überschreitet. Für ein stehendes oder startendes Fahrzeug wird als longitudinaler Grenzwert 1 Meter angenommen.

Die Modellierung der Reaktionszeit des Fahrers, welche sich aus der Entscheidungszeit, der Betätigungszeit und der Ansprechzeit der Betätigungseinrichtung zusammensetzt, erfolgt folgendermaßen:
Weil der Fahrer von der Risiko- oder Problemsituation überrascht wird, werden Worst-Case - Szenarien berücksichtigt.

Die Entscheidungszeit beinhaltet die Schritte Wahrnehmen, Begreifen, Auswahl der Reaktionshandlung.

Die Entscheidungszeit kann zwischen einer minimalen und einer maximalen Entscheidungszeit liegen. Allerdings kann die tatsächliche Entscheidungszeit abhängig von der jeweiligen Situation und dem Aufmerksamkeitsgrad des Fahrers davon auch abweichen.

Untersuchungen haben ergeben, dass bei einem unerfahrenen Fahrer (entsprechend der Beherrschbarkeitsklasse C0) die minimale Entscheidungszeit bei 1,5 Sekunden und die maximale Entscheidungszeit bei etwa 2 Sekunden liegen kann.

Bei einem durchschnittlichen Fahrer (entsprechend der Beherrschbarkeitsklasse C1) kann die Entscheidungszeit zwischen einer minimalen Entscheidungszeit von 1,2 Sekunden und einer maximalen Entscheidungszeit von etwa 1,5 Sekunden liegen.

Die Entscheidungszeit liegt bei fortgeschrittenen Fahrern Fahrer (entsprechend der Beherrschbarkeitsklasse C2) zwischen einer minimalen Entscheidungszeit von 1,0 Sekunden und einer maximalen Entscheidungszeit von etwa 1,3 Sekunden.

Die Betätigungszeit ist die Zeit zwischen der Auswahl der Betätigungshandlung und der Betätigung der Betätigungseinrichtung.

Auch hier kann zwischen den drei Fahrerbefähigungstypen differenziert werden:
Beim unerfahrenen Fahrer (entsprechend der Beherrschbarkeitsklasse C0) liegt - wie Untersuchungen ergeben haben - die Betätigungszeit im Allgemeinen bei 0,5 Sekunden.

Bei durchschnittlichen Fahrern (entsprechend der Beherrschbarkeitsklasse C1) liegt in den meisten Fällen die Betätigungszeit bei 0,3 Sekunden Fortgeschrittene Fahrer (entsprechend der Beherrschbarkeitsklasse C2) weisen meist Betätigungszeiten von etwa 0,2 Sekunden auf.

Die Ansprechzeit der Betätigungseinrichtung (beispielsweise Bremsbetätigungseinrichtung) ist fahrerunabhängig und hängt zum Beispiel von mechanischen Faktoren ab. Sie beträgt in den meisten Fällen etwa 0,3 Sekunden. Abhängig vom Zustand der Betätigungseinrichtung ist auch hier eine Abweichung nach oben oder unten möglich.

Zusammenfassend kann also beispielsweise abhängig von den Fahrerbefähigungstypen mit folgenden Reaktionszeiten gerechnet werden:
Unerfahrene Fahrer (entsprechend der Beherrschbarkeitsklasse C0): 2,3 bis 2,8 Sekunden;
Durchschnittliche Fahrer (entsprechend der Beherrschbarkeitsklasse C1): 1,8 bis 2,1 Sekunden.

Fortgeschrittene Fahrer (entsprechend der Beherrschbarkeitsklasse C0): 1,5 bis 1,8 Sekunden.

Die angegebenen Zeiten verstehen sich als Durchschnittswerte, welche in den meisten Fällen zutreffend sind. Jedoch können die Zeiten - je nach Situation - im Einzelfall von den angegebenen Werten nach oben oder unten abweichen.

### Beispiel:

- Umgebungsbedingungen: nasse Freilandstraße, Geschwindigkeit des Fahrzeuges 100 km/h, Linkskurve; das Fahrzeug weist pro Rad einen Elektromotor auf.
- Fehler: Der Elektromotor eines Vorderrades liefert plötzlich das maximale positive e Drehmoment.
- Modellierte Reaktionszeiten (Annahme: keine Vorlaufzeit, Fahrer ist völlig überrascht von dem Defekt):
   a) Beherrschbarkeitsklasse C0: 2,8 Sekunden -> Ein unerfahrener Fahrer kann das Fahrzeug nicht kontrollieren (Maßnahmen: Fuß weg vom Gaspedal, Versuch zu bremsen, Gegenlenken - mit längeren Verzögerungen)
   b) Beherrschbarkeitsklasse C1: 2,1 Sekunden -> Ein durchschnittlicher Fahrer kann das Fahrzeug nicht kontrollieren (Maßnahmen: Fuß weg vom Gaspedal, Versuch zu bremsen, Gegenlenken - mit durchschnittlichen Verzögerungen)
   c) Beherrschbarkeitsklasse C1: 2,1 Sekunden -> Ein durchschnittlicher Fahrer kann das Fahrzeug nicht kontrollieren (Maßnahmen: Fuß weg vom Gaspedal, Gegenlenken - mit geringen Verzögerungen)
- Ergebnis: Situation ist nicht beherrschbar (C3)

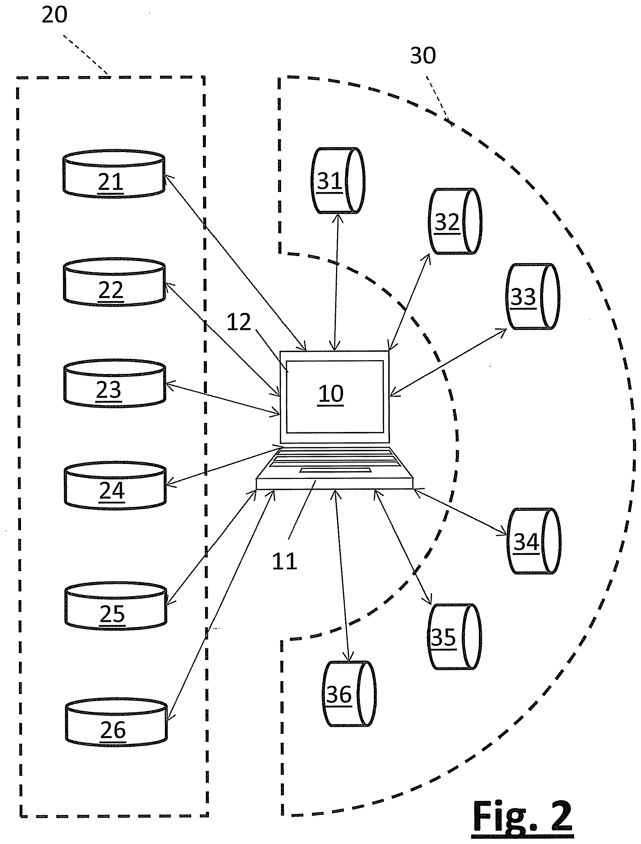

Fig. 2 zeigt eine Einrichtung zur Durchführung des beschriebenen Verfahrens zur Beurteilung der Beherrschbarkeit eines Fahrzeuges durch einen Fahrer in zumindest einer Risiko- oder Problemsituation, mit einer Bedieneinheit 10 mit Ein- und Ausgabevorrichtung 11, 12, einer Recheneinheit 20 und einer Dateneinheit 30. Die Bedieneinheit 10, die Recheneinheit 20 und/oder die Dateneinheit 30 können in ein Zentralgerät integriert oder räumlich getrennt, insbesondere als Teil eines dezentralen Computernetzwerkes ausgebildet sein.

Die Recheneinheit 20 kann aus mehreren Programmmodulen (Softwarewerkzeugen) bestehen, beispielsweise einem ersten Programmmodul 21 zum Modellieren des Antriebsstranges und Antriebsstrangkomponenten (zum Beispiel Software AVL CRUISE), einem zweiten Programmmodul 22 zum Modellieren der Fahrdynamik, einem dritten Programmmodul 23 zum Modellieren von Situations- und Umweltbedingungen, einem vierten Programmmodul 24 zum Modellieren der Fahrerreaktionen in Abhängigkeit des Fahrerbefähigungstyps, einem fünften Programmmodul 25 zum Simulierung des dynamischen Fahrzeugverhaltens bei Eintreten der Risiko- oder Problemsituation und einem sechsten Programmmodul 26 zur Bewertung der Beherrschbarkeit des Fahrzeuges. Dabei können zumindest zwei oder mehrere Programmmodule in zumindest einem Programmkomplex zusammengefasst sein. Beispielsweise können zweites und drittes Programmmodul 22, 23 zu einem einzigen Programmmodul zum Modellieren der Fahrdynamik und der Situations- und Umweltbedingungen zusammengefasst werden. Eine solche die zweiten und dritten Programmmodule vereinende Funktionalität bietet beispielsweise das gewerblich erhältliche Softwarewerkzeug "CARMAKER" (IPG).

Die einzelnen Programmmodule 21, 22, 23, 24, 25 der Recheneinheit 20 können in einem Zentralgerät angeordnet oder räumlich getrennt voneinander als Teil eines dezentralen Computernetzwerk ausgebildet sein.

Die Dateneinheit 30 kann einen oder mehrere Datenmodule, beispielsweise ein erstes Datenmodul 31 für Informationen über Risiko- und Problemsituationen, ein zweites Datenmodul 32 für Informationen zum Fahrzeug und dem Antriebsstrang, ein drittes Datenmodul 33 Informationen von Situations- und Umweltbedingungen, ein viertes Datenmodul 34 für Informationen über den Fahrertyp, ein fünftes Datenmodul 35 für fahrertypbezogenen Reaktionszeiten und ein sechstes Datenmodul 36 für definierte Grenzwerten für die laterale und longitudinale Abweichung des Fahrzeuges aufweisen. Zumindest zwei oder mehrere Datenmodule können in zumindest einem Datenkomplex zusammengefasst sein.

Die einzelnen Datenmodule 31, 32, 33, 34, 35, 36 der Dateneinheit 30 können in einem Zentralgerät angeordnet oder räumlich getrennt voneinander als Teil eines dezentralen Computernetzwerk ausgebildet sein.

In den Datenmodulen sind alle nötigen Informationen und Kriterien als Kennlinien, Kennfelder, Tabellen oder Matrizen abgelegt und/oder können während des Verfahrens ergänzt bzw. eingegeben werden. Die entsprechenden Daten und Informationen können bei Bedarf über die Recheneinheit 20, insbesondere durch die einzelnen Programmmodule 21, 22, 23, 24, 25 abgerufen werden.

Die Erfindung wurde hier zwar anhand einer abrupten Drehmomentzunahme bei einem elektrischen Antriebsmotor für ein Rad eines Fahrzeuges erläutert. Selbstverständlich kann die Erfindung aber auch bei anderen Risiko- oder Problemsituationen angewendet werden, wie abrupter Drehmomentabnahme, Drehmomentumkehr, Blockieren, oszillierendem Drehmoment bei einem oder mehreren Rädern, Lenkungssystem- oder Bremssystembedingten Problemsituationen, Kurzschlüssen oder Ausfall von Komponenten im elektrischen System, oder dergleichen.

Zusätzlich zur Simulation kann für jede Risiko- oder Problemsituation die Fehlertoleranzzeit ermittelt werden. Die auf den lateralen und longitudinalen Abweichungen basierende Fehlertoleranzzeit ist jene Zeit, die vergeht, bevor die Risiko- oder Problemsituation unbeherrschbar wird. Die Fehlertoleranzzeit wird verwendet, um die den Sicherheitssystemen (Überwachungssoftware, ESP,...) zur Verfügung stehende Fehlerreaktionszeit zu berechnen, bevor der Effekt aus der Risiko- oder Problemsituation sichtbar wird. Die Sicherheitssysteme müssen so ausgelegt sein, dass die Sicherheitsmaßnahmen innerhalb der Fehlerreaktionszeit greifen.

Die Reaktion der drei Fahrertypen (Bremspedalkraft, Lenkungswinkel, etc.) wird abhängig von der jeweiligen Risiko- oder Problemsituation modelliert, da jede Risiko- oder Problemsituation andere Reaktionen erfordert. Zusätzlich wird für jeden Fahrerbefähigungstyp für dieselbe Risiko- oder Problemsituation die vorausgesagte Fahrerreaktion (zum Beispiel Gegenlenken) verschieden modelliert.

## Patentansprüche

1. Verfahren zur Beurteilung der Beherrschbarkeit eines Fahrzeuges, insbesondere eines Elektrofahrzeuges, durch einen Fahrer in zumindest einer Risiko-oder Problemsituation, umfassend folgende Schritte:
a. Modellieren des Antriebsstranges und der Fahrdynamik des Fahrzeugs,
b. Modellieren von Situations- und Umweltbedingungen,
c. Auswählen zumindest einer Risiko- oder Problemsituation,
d. Auswählen zumindest eines Fahrerbefähigungstyps, vorzugsweise aus der Gruppe unerfahrener Fahrer, durchschnittlicher Fahrer, und fortgeschrittener Fahrer,
e. Modellieren der Fahrerreaktion in Abhängigkeit des ausgewählten Fahrerbefähigungstyps,
f. Simulieren des dynamischen Fahrzeugverhaltens längs- und quer zu einer geplanten Bahnkurve auf der Basis des Antriebsstrang- und Fahrdynamikmodells für die vorgegebenen Situations- und Umweltbedingungen bei Eintreten der ausgewählten Risiko- oder Problemsituation unter Annahme eines Fahrereingriffes mit fahrerbefähigungstypabhängiger Reaktionszeit, und **gekennzeichnet durch** folgende Schritte :
g. Berechnen der maximalen lateralen und longitudinalen Abweichung von der geplanten Bahnkurve zwischen dem Auftreten der Risiko-oder Problemsituation und der Wiedererlangung der vollen Kontrolle durch den Fahrer,
h. Bewerten der Beherrschbarkeit des Fahrzeugs durch den Fahrer in der Risiko- oder Problemsituation auf Grund der maximalen lateralen und/oder longitudinalen Abweichung des Fahrzeugs von der geplanten Bahnkurve.

2. Verfahren nach Anspruch 1, **dadurch gekennzeichnet, dass** das Fahrzeug als beherrschbar für zumindest den betrachteten Fahrerbefähigungstyp, bewertet wird, wenn die maximalen lateralen und longitudinalen Abweichungen des Fahrzeugs definierte Grenzwerte für die laterale bzw. longitudinale Abweichung des Fahrzeuges nicht überschreiten.

3. Verfahren nach Anspruch 1 oder 2, **dadurch gekennzeichnet, dass** das Fahrzeug als allgemein beherrschbar bewertet wird, wenn die maximalen lateralen und longitudinalen Abweichungen des Fahrzeugs für alle Fahrertypen definierte Grenzwerte für die laterale bzw. longitudinale Abweichung des Fahrzeuges nicht überschreiten.

4. Verfahren nach Anspruch 2 oder 3, **dadurch gekennzeichnet, dass** als lateraler Grenzwert eine seitliche Abweichung von 0,5 Meter außerhalb der Fahrspur der geplanten Bahnkurve definiert wird.

5. Verfahren nach einem der Ansprüche 1 bis 4, **dadurch gekennzeichnet, dass** als longitudinaler Grenzwert eine Abweichung von 1,5 Sekunden in Längsrichtung der geplanten Bahnkurve - in Bezug auf einen geplanten Bahnpunkt ohne auftretender Risiko- oder Problemsituation - definiert wird

6. Verfahren nach einem der Ansprüche 1 bis 5, **dadurch gekennzeichnet, dass** für einen unerfahrenen Fahrer eine Reaktionszeit von 2,3 bis 2,8 Sekunden der Simulation des dynamischen Fahrzeugverhaltens zugrunde gelegt wird.

7. Verfahren nach einem der Ansprüche 1 bis 6, **dadurch gekennzeichnet, dass** für einen durchschnittlichen Fahrer eine Reaktionszeit von 1,8 bis 2,1 Sekunden der Simulation des dynamischen Fahrzeugverhaltens zugrunde gelegt wird.

8. Verfahren nach einem der Ansprüche 1 bis 7, **dadurch gekennzeichnet, dass** für einen fortgeschrittenen Fahrer eine Reaktionszeit von 1,5 bis 1,8 Sekunden der Simulation des dynamischen Fahrzeugverhaltens zugrunde gelegt wird.

9. Verfahren nach einem der Ansprüche 1 bis 8, **dadurch gekennzeichnet, dass** jedem Fahrerbefähigungstyp eine Beherrschbarkeitsklasse (C0, C1, C2) zugeordnet wird.

10. Verfahren nach Anspruch 9, **dadurch gekennzeichnet, dass** die niedrigste Beherrschbarkeitsklasse aller erfolgreich simulierten Fahrerbefähigungstypen als Beherrschbarkeitsklasse für eine Gefährdungs- und Risikoabschätzung verwendet wird.

## Claims

1. A method for evaluating the controllability of a vehicle, especially an electric vehicle, by a driver in at least one risky or problematic situation, including the following steps:
a. modelling the drive train and the driving dynamics of the vehicle;
b. modelling the situational and environmental conditions;
c. selecting at least one risky or problematic situation;
d. selecting at least one driver capability type, preferably from the group of inexperienced drivers, average drivers and experienced drivers;
e. modelling the reaction of the driver as a function of the selected driver capability type;
f. simulating the dynamic vehicle behaviour in the longitudinal and transverse directions of a planned trajectory on the basis of the drive train model and driving dynamics model for the predetermined situational and environmental conditions when the selected risky or problematic situation occurs, under the assumption of driver intervention with a reaction time which is dependent on the driver capability type;
and **characterised by** the following steps:
g. calculating the maximum lateral and longitudinal deviation from the planned trajectory between the occurrence of the risky or problematic situation and the regaining of the complete control by the driver;
h. evaluating the controllability of the vehicle by the driver in the risky or problematic situation on the basis of the maximum lateral and/or longitudinal deviation of the vehicle from the planned trajectory.

2. A method according to claim 1, **characterised in that** the vehicle is evaluated as controllable for at least the considered driver capability type if the maximum lateral and longitudinal deviations of the vehicle do not exceed defined limit values for the lateral and longitudinal deviation of the vehicle.

3. A method according to claim 1 or 2, **characterised in that** the vehicle is evaluated as generally controllable if the maximum lateral and longitudinal deviations of the vehicle for all types of drivers do not exceed defined limit values for the lateral and longitudinal deviation of the vehicle.

4. A method according to claim 2 or 3, **characterised in that** a lateral deviation of 0.5 meters outside of the lane of the planned trajectory is defined as the lateral limit value.

5. A method according to one of the claims 1 to 4, **characterised in that** a deviation of 1.5 seconds in the longitudinal direction of the planned trajectory, relating to a planned trajectory point without the occurring risky or problematic situation, is defined as the longitudinal limit value.

6. A method according to one of the claims 1 to 5, **characterised in that** for an inexperienced driver a reaction time of 2.3 to 2.8 seconds is used as the basis for the simulation of the dynamic vehicle behaviour.

7. A method according to one of the claims 1 to 6, **characterised in that** for an average driver a reaction time of 1.8 to 2.1 seconds is used as the basis for the simulation of the dynamic vehicle behaviour.

8. A method according to one of the claims 1 to 7, **characterised in that** for an experienced driver a reaction time of 1.5 to 1.8 seconds is used as the basis for the simulation of the dynamic vehicle behaviour.

9. A method according to one of the claims 1 to 8, **characterised in that** a controllability class (C0, C1, C2) is assigned to each driver capability type.

10. A method according to claim 9, **characterised in that** the lowest controllability class of all successfully simulated driver capability types is used as the controllability class for hazard and risk assessment.

## Revendications

1. Procédé d'évaluation du degré de contrôle d'un véhicule, notamment d'un véhicule électrique par le conducteur dans au moins une situation de risques ou de difficultés comprenant les étapes suivantes consistant à :
a. modéliser la ligne de transmission et la dynamique de roulement du véhicule,
b. modéliser les conditions de situation et d'environnement,
c. sélectionner au moins une situation de risques ou de difficultés,
d. sélectionner au moins un type de capacité de conducteur, de préférence dans le groupe suivant : conducteur inexpérimenté, conducteur moyen, conducteur expérimenté,
e. modéliser la réaction du conducteur en fonction du type de capacité de conducteur choisie,
f. simuler le comportement dynamique du véhicule dans la direction longitudinale et la direction transversale d'une trajectoire planifiée en s'appuyant sur le modèle de ligne de transmission et de dynamique de roulement pour les conditions de situation et d'environnement à l'entrée de la situation choisie de risques ou de difficultés en supposant une intervention du conducteur avec un temps de réaction dépendant de la capacité du conducteur, et
**caractérisé par** les étapes suivantes consistant à :
g. calculer l'écart maximum latéral et longitudinal par rapport à la trajectoire planifiée entre l'arrivée de la situation de risques ou de difficultés et la reprise du contrôle total par le conducteur,
h. évaluer le degré de contrôle du véhicule par le conducteur dans la situation de risques ou de difficultés en se fondant sur l'écart latéral et/ou longitudinal maximum du véhicule par rapport à la trajectoire planifiée.

2. Procédé selon la revendication 1,
**caractérisé en ce que**
le véhicule est considéré comme pouvant être contrôlé par le type de capacité de conducteur considéré, si les écarts latéraux et longitudinaux maximum du véhicule ne dépassent pas des valeurs limites définies pour l'écart latéral et l'écart longitudinal du véhicule.

3. Procédé selon la revendication 1 ou 2,
**caractérisé en ce que**
le véhicule est considéré comme étant globalement contrôlable si les écarts latéraux et longitudinaux maximum du véhicule pour tous les types de conducteurs ne dépassent pas les valeurs limites définies pour l'écart latéral ou l'écart longitudinal du véhicule.

4. Procédé selon la revendication 2 ou 3,
**caractérisé en ce que**
comme valeur limite latérale, on définit un écart latéral de 0,5 mètre au-delà de la trace de la trajectoire planifiée.

5. Procédé selon l'une des revendications 1 à 4,
**caractérisé en ce que**
comme valeur limite longitudinale, on définit un écart de 1,5 seconde dans la direction longitudinale de la trajectoire planifiée - par rapport à un point planifié de la trajectoire sans que se présente la situation de risques ou de difficultés.

6. Procédé selon l'une des revendications 1 à 5,
**caractérisé en ce que**
pour un conducteur inexpérimenté on utilise un temps de réaction de 2,3-2,8 secondes de la simulation du comportement dynamique du véhicule.

7. Procédé selon l'une des revendications 1 à 6,
**caractérisé en ce que**
pour un conducteur moyen, on fixe un temps de réaction de 1,8 jusqu'à 2,1 secondes de simulation du comportement dynamique du véhicule.

8. Procédé selon l'une des revendications 1 à 7,
**caractérisé en ce que**
pour un conducteur expérimenté on utilise un temps de réaction de 1,5 - 1,8 seconde de la simulation du comportement dynamique du véhicule.

9. Procédé selon l'une des revendications 1 à 8,
**caractérisé en ce qu'**
on associe à chaque type de capacité de conducteur, une classe de degré de contrôle (C0, C1, C2).

10. Procédé selon la revendication 9,
**caractérisé en ce qu'**
on utilise la classe de degré de contrôle la plus basse de tous les types de capacité de conducteur, simulés comme classes de degré de contrôle pour une évaluation du danger et du risque.
